## Europäisches Patentamt

## European Patent Office

## Office européen des brevets

(11) Numéro de publication: **0 186 225 B1**

---

# FASCICULE DE BREVET EUROPEEN

(45) Date de publication du fascicule du brevet:
**21.02.90**

(51) Int. Cl.⁵: **H 01 J 31/26, H 01 J 1/34, H 01 J 9/12, H 01 L 27/14**

(21) Numéro de dépôt: **85201871.2**

(22) Date de dépôt: **14.11.85**

---

(54) Capteur d'images pour caméra fonctionnant en mode "jour-nuit".

---

(30) Priorité: **30.11.84 FR 8418285**

(43) Date de publication de la demande:
**02.07.86 Bulletin 86/27**

(45) Mention de la délivrance du brevet:
**21.02.90 Bulletin 90/8**

(84) Etats contractants désignés:
**DE FR GB**

(56) Documents cités:
**FR-A- 2 239 011**
**US-A- 3 735 139**
**US-A- 3 887 810**

**PROCEEDINGS OF THE INTERNATIONAL CONFERENCE ON THE APPLICATION OF CHARGE-COUPLED DEVICES, 29-31 octobre 1975, pages 133-145, 2nd Conference, Edinburgh, GB; J.B. BARTON et al.: "Performance analyis of EBS-CCD imaging tubes/status of ICCD development"**

(73) Titulaire: **LABORATOIRES D'ELECTRONIQUE PHILIPS, 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **DE GB**

(72) Inventeur: **Lemonier, Michel Gilles, Société Civile S.P.I.D. 209, rue de l'Université, F-75007 Paris (FR)**
Inventeur: **Petit, Maurice Louis Joseph, Société Civile S.P.I.D. 209, rue de l'Université, F-75007 Paris (FR)**

(74) Mandataire: **Landousy, Christian et al, Société Civile S.P.I.D. 209, Rue de l'Université, F-75007 Paris (FR)**

---

ACTORUM AG

# Description

L'invention concerne un capteur d'images pour caméra munie d'un double fonctionnement, en mode «jour» et en mode «nuit», présentant dans une enveloppe vidée d'air:

a) sur une fenêtre d'entrée, une photocathode semi-transparente pour transmettre les photons incidents ou les convertir en photoélectrons selon respectivement le mode «jour» ou le mode «nuit»,

b) sur un support de sortie, un détecteur pouvant convertir, en un signal électrique d'images, respectivement les photons incidents ou les photoélectrons, selon le mode «jour» ou le mode «nuit»,

c) des moyens électroniques de focalisation des photoélectrons sur le détecteur, et des moyens optiques de focalisation des photons sur la photocathode ou le détecteur selon respectivement le mode «nuit» ou le mode «jour».

Une invention de ce genre est connue du brevet des Etats-Unis n° 3 735 139. Il y est décrit un système de photodétection disposant d'une possibilité de double fonctionnement en mode «lumière intense» et en mode «obscurité».

Pour cela, dans une enveloppe à vide de forme tubulaire sont disposés à une extrémité une photocathode, pouvant être semi-transparente, et à l'autre extrémité de l'enveloppe, un détecteur formé d'une ligne de photodiodes. A l'intérieur de l'enveloppe est disposée une structure de canon électronique formée d'un certain nombre d'électrodes mises à des hautes tensions régulièrement réparties à l'aide de ponts de résistances. A l'extérieur de l'enveloppe sont disposées des bobines de déflexion et des bobines de focalisation pour agir sur les photoélectrons émis et les défléchir et les focaliser sur le détecteur. Egalement à l'extérieur de l'enveloppe, mais dans ce cas pour traiter le flux de lumière incident, sont disposées plusieurs lentilles qui permettent de focaliser une image soit directement sur le détecteur lorsque la lumière est intense, soit sur la photocathode lors d'un fonctionnement en obscurité. Il est nécessaire alors d'intervenir sur le nombre et/ou la position de ces lentilles pour assurer le double fonctionnement. Le détecteur est à la fois sensible au rayonnement direct de photons et au flux de photoélectrons émis par la photocathode en réponse au rayonnement de photons.

Mais ce système présente plusieurs inconvénients. Tout d'abord les moyens électroniques de focalisation, qui font appel à une technique éprouvée sont volumineux, d'une mise en oeuvre longue et délicate, nécessitant un empilement d'électrodes sous haute tension. Il s'y rajoute des moyens électroniques de balayage imposés par le fait que le flux d'électrons focalisé doit être déplacé sur toute la surface utile du détecteur pour engendrer une image à deux dimensions. De ce fait, le temps de pose ou «temps d'intégration» de chaque point de l'image est limité à la durée d'une ligne. En outre, les moyens optiques de focalisation, présentent des inconvénients, dus en particulier au fait qu'il est nécessaire de modifier le nombre et la disposition des lentilles selon le mode de fonctionnement choisi pour pouvoir focaliser le rayonnement de photons soit sur la photocathode soit sur le détecteur et ceci sur une grande profondeur.

Le but de l'invention est donc de supprimer les inconvénients qui viennent d'être évoqués notamment en donnant au capteur d'images une grande compacité par une conception modifiée.

Pour cela, l'invention telle que définie dans le préambule est remarquable:

— en ce que la photocathode semi-transparente est constituée d'une lame ayant au moins une couche active d'une épaisseur de l'ordre de 0,5 μm d'un matériau n-aire III-V,

— en ce que le détecteur est constitué d'un dispositif à transfert de charges bidimensionnel, qui comprend un substrat suffisamment mince afin que les photons et les photoélectrons agissent par l'arrière sur la partie active du dispositif à transfert de charges à travers le substrat mince,

— et en ce que la photocathode semitransparente et le dispositif à transfert de charges sont disposés à une distance de l'ordre de 2 mm de telle sorte que les photoélectrons sont focalisés par proximité, sans électrode de focalisation sur le dispositif à transfert de charges.

La photocathode semi-transparente est placée à l'intérieur de l'enveloppe à vide constituant le capteur d'images. La fenêtre d'entrée est constituée d'un substrat transparent au rayonnement, en verre ou en oxyde monocristallin tel que le corindon, sur lequel est déposée la photocathode semi-transparente. Cette photocathode comprend une couche active constituée d'un matériau n-aire III-V par exemple en arséniure de gallium GaAs. La méthode de réalisation de la fenêtre d'entrée munie d'une photocathode semi-transparente reprend, dans ses différentes étapes, celle utilisée pour une photocathode non transparente.

Elle consiste à faire croître, typiquement par épitaxie en phase liquide, sur un substrat provisoire d'un composé III-V, tel que l'arséniure de gallium GaAs, une couche dite d'arrêt chimique $Ga_{1-x}Al_xAs$, qui agit comme une couche d'arrêt vis-à-vis de l'action de la solution de décapage utilisée ensuite pour enlever le substrat provisoire. Une épaisseur de couche d'arrêt de l'ordre de 0,5 à 5 μm a conduit à des résultats satisfaisants. On fait croître ensuite une couche dite active, généralement d'arséniure de gallium très fortement dopé jusqu'à $10^{19}$ atomes/cm$^3$, par exemple au moyen de germanium (Ge) ou de zinc (Zn). Une épaisseur de couche active de l'ordre de 0,5 μm convient pour une application en tant que photocathode semi-transparente. On forme enfin une couche passivante pour empêcher la diffusion de substances indésirables dans la couche active lors des étapes ultérieures de scellement, et pour diminuer la recombinaison des porteurs de charge à l'interface. Une couche passivante de $Ga_{1-y}Al_yAs$ d'une épaisseur de couche de l'ordre de 5 μm satisfait à cet usage.

Cette hétérostructure semiconductrice, munie de couches de protection $SiO_2$ et d'adaptation d'indice $Si_3N_4$, est alors liée à un support, transparent aux photons, généralement formé d'un verre borosilicate. La liaison est obtenue par thermocompression en élevant la température juste au-dessus de la tem-

pérature de ramollissement du verre. Une fois la liaison effectuée, le substrat provisoire et la couche d'arrêt sont décapés au moyen de deux solutions d'attaque différentes; dans l'exemple décrit, le substrat provisoire de GaAs est attaqué au moyen d'un mélange d'ammoniaque et d'eau oxygénée, alors que la couche d'arrêt, insensible à cette première solution d'attaque, est retirée au moyen d'acide fluorhydrique après protection du support vitreux. Le produit obtenu comprend alors un support vitreux faisant office de fenêtre d'entrée, une couche d'adaptation d'indice de $Si_3N_4$, une couche de protection de $SiO_2$, une couche passivante et une couche active de très bonne qualité. Les couches d'adaptation d'indice de $Si_3N_4$, de protection de $SiO_2$, et la passivante peuvent éventuellement être modifiées en nombre et en nature, en fonction de l'application.

Enfin, avant utilisation de cette structure semiconducteur-support vitreux comme photocathode, on procède à une désorption sous vide de la surface de la couche active de GaAs, par chauffage jusqu'à une température proche du point d'évaporation congruente du composé, qui, pour le GaAs, est voisin de 630°C.

La couche active est alors recouverte d'une couche de cesium-oxygène au cours d'un processus de cesiation sous vide à température ambiante afin de donner à la couche active de GaAs une sensibilité photoélectrique maximale.

Pour mieux contrôler l'évolution des contraintes pouvant apparaître dans la couche active en GaAs, il est possible d'utiliser un support vitreux constitué d'un empilement de plusieurs lames de verres aux propriétés thermoélastiques et thermovisqueuses appropriées, connu de l'art antérieur.

La photocathode en arséniure de gallium ainsi réalisée, ne présente que de très faibles irrégularités de surface, ce qui permet d'utiliser une focalisation de proximité pour focaliser les photoélectrons.

L'épaisseur de la couche active de GaAs est typiquement de 0,5 µm selon l'invention. Cette épaisseur constitue un compromis, nécessité par l'objet de l'invention qui est, selon le mode de fonctionnement, de disposer d'une photocathode qui absorbe les photons en mode «nuit» et au contraire les transmet en mode «jour». La semi-transparence de la photocathode dépend évidemment de la longueur d'onde de la lumière incidente. Le spectre de lumière qui est principalement concerné par l'invention s'étend de 0,5 µm à 0,9 µm environ. Dans cette gamme c'est la couche active de GaAs qui gouverne les mécanismes d'absorption et de transmission de photons.

Pour cette gamme de longueurs d'ondes les valeurs de la transparence sont indiquées dans le tableau 1:

TABLEAU 1

| Longueurs d'ondes en µm | 0,5 | 0,6 | 0,7 | 0,8 | 0,9 | 1,0 |
|---|---|---|---|---|---|---|
| Transparence en % | 5 | 8 | 18 | 40 | 68 | 70 |

Ces valeurs sont à associer aux valeurs de sensibilité du dispositif à transfert de charges (décrit ci-après) pour la même gamme de longueurs d'ondes indiquées dans le tableau 2:

TABLEAU 2

| Longueurs d'ondes en µm | 0,5 | 0,6 | 0,7 | 0,8 | 0,9 | 1,0 |
|---|---|---|---|---|---|---|
| Sensibilité (efficacité quantique %) | 50 | 65 | 75 | 70 | 50 | 25 |

Ces valeurs montrent que la transparence de la photocathode en GaAs croît avec la longueur d'onde (dans la gamme indiquée) et que les valeurs maximales de transparence et le maximum de sensibilité du dispositif à transfert de charges se situent sensiblement pour les mêmes longueurs d'ondes.

Un dispositif à transfert de charges est un registre à décalage pour des signaux analogiques. Sous sa forme la plus simple, il est formé d'un substrat monocristallin semi-conducteur sur lequel sont placées différentes électrodes isolées du substrat par des couches d'oxydes.

Le substrat est généralement du silicium et l'isolant est de l'oxyde de silicium. Le dispositif à transfert de charges stocke les échantillons du signal sous la forme de paquets de charges, puis les transfère en parallèle jusqu'à un amplificateur de charges, tout en gardant les paquets de charges isolés les uns des autres. Selon les technologies utilisées ceci nécessite deux, trois ou quatre électrodes consécutives pour former un élément mémoire. Pour effectuer les transferts, on applique sur les électrodes des signaux d'horloge périodiques dont les phases sont décalées de une demie, un tiers ou un quart de période d'horloge suivant le nombre d'électrodes constituant chaque élément mémoire. Il se crée ainsi des puits de potentiel qui sont translatés progressivement sur toute la ligne formée d'une suite d'éléments mémoire. Les charges qui sont générées lors de la prise de l'image sont ainsi translatées par le déplacement de ces puits de potentiel jusqu'à l'amplificateur de charge en sortie.

Les dispositifs à transfert de charges destinés à l'imagerie remplissent une double fonction, celle de détection de l'image et celle de transfert des charges créées. Ces dispositifs peuvent être organisés avec une zone sensible et une zone mémoire, elles-mêmes constituées d'un ensemble de lignes et de colonnes. Leur structure est alors dite à «transfert de trame» connue de l'homme de l'art. Cette structure est bien adaptée à une détection par la face arrière du dispositif à transfert de charges.

Selon l'invention on utilise le dispositif à transfert de charges (DTC) à deux dimensions en exploitant pour l'injection des charges la propriété qu'il a d'être sensible à la fois aux photons et aux photoélectrons. Pour cela, il est nécessaire d'adapter le DTC à cette application. En effet, tel que réalisé habituellement le DTC présente en surface des couches de protection, principalement d'oxydes, ainsi que des contacts et des connexions qui nuisent à la création des charges par les photoélectrons dans les puits de potentiel placés sous les électrodes. Il est donc nécessaire de créer les charges par l'arrière du DTC. Pour cela on réduit préalablement, au niveau de la zone sensible, l'épaisseur du substrat de silicium, qui initialement est de l'ordre de 400 µm sur lequel est déposée la structure électronique constituant le DTC. Par ailleurs, la face arrière du DTC aminci devra être en régime d'accumulation des porteurs majoritaires, pour abaisser le taux de recombinaison de surface.

Pour cela, on réalise le DTC sur un matériau épitaxié, constitué d'un substrat fortement dopé $P^{++}$ au bore ($10^{19}$ atomes/cm$^3$), sur lequel est déposée une couche épitaxiée P de 8 à 12 µm d'épaisseur, faiblement dopée au bore ($5 \cdot 10^{14}$ atomes/cm$^3$) sur laquelle est réalisé le circuit. La réduction d'épaisseur s'opère en deux temps par polissage chimique, à la température ambiante, sur la zone sensible.

Tout d'abord une préattaque chimique rapide, isotrope, va consister à enlever la majeure partie du substrat, soit environ 380 µm. Ceci se fait à l'aide d'une solution d'acide nitrique, d'acide acétique et d'acide fluorhydrique dans les proportions 5 : 3 : 3. La régularité de l'attaque est très sensible aux conditions d'agitation du bain et de l'échantillon. Un mouvement rotatif à 200 tr/minute conduit à une bonne régularité d'épaisseur finale. Cette attaque chimique est arrêtée dès l'apparition d'une teinte pourpre de l'échantillon examiné en transparence, ce qui correspond à une épaisseur restante d'environ 20 µm.

Ensuite on effectue une attaque lente destinée à ne laisser en face arrière qu'une couche surdopée de 0,5 µm à 1 µm d'épaisseur. Cette attaque est faite à l'aide d'une solution d'acide nitrique, d'acide acétique et d'acide fluorhydrique dans les proportions 3 : 8 : 1, en présence de peroxyde d'hydrogène à raison de 5 ml pour 350 ml de solution. L'attaque s'arrête pour des dopages inférieures à $10^{17}$ atomes/cm$^3$. Cette dernière opération assure à la fois une bonne régularité d'épaisseur, et conserve une couche surdopée $P^+$ en face arrière réalisant le régime d'accumulation recherché.

La prise des contacts sur la périphérie du dispositif à transfert de charges est réalisée avant les attaques chimiques. Cette prise de contact s'effectue à l'aide de pastilles métalliques placées entre les plots de contact du dispositif à transfert de charges et un support de montage en corindon ou en verre sur lequel des pistes conductrices sont disposées soit par sérigraphie soit par gravure. La périphérie de l'échantillon et le substrat sont protégés pendant l'attaque chimique par un masque de cire déposé au pinceau.

L'épaisseur de la zone sensible du dispositif à transfert de charges est ainsi réduite d'environ 400 µm à environ 10 µm. Ceci permet aux photons et aux photoélectrons d'être absorbés à une distance suffisamment proche des puits de potentiel pour que les charges créées y parviennent sans recombinaison de volume ou de surface, ni diffusion latérale. Les charges ainsi stockées dans la structure à deux dimensions sont lues, ligne par ligne, en les transportant dans un registre à décalage de sortie dont la lecture fournit un signal électrique. Celui-ci peut alors être visualisé par des dispositifs habituels, par exemple un téléviseur.

Une caractéristique essentielle de l'invention consiste en ce que la photocathode semi-transparente et le dispositif à transfert de charges sont disposés de telle sorte que les photoélectrons, issus de la photocathode, sont focalisés par proximité sur le dispositif à transfert de charges. Cette focalisation se caractérise par une très faible distance entre les deux éléments mis en regard. Pour le capteur d'images, selon l'invention, cette distance est typiquement de l'ordre de 2 mm, ce qui supprime l'emploi de toute électrode intermédiaire d'accélération et de focalisation. L'image électronique en provenance de la photocathode se trouve ainsi reproduite sur le détecteur, les distorsions et les aberrations étant suffisamment faibles pour ne pas nuire à la qualité de l'image.

La photocathode et le dispositif à transfert de charges sont reliés aux bornes d'un générateur haute tension, typiquement de 10 kvolts selon l'invention, soit un champ électrique de 5 kvolts/mm.

En appelant G le gain électronique du DTC tel que la charge incidente soit multipliée par G pour obtenir la charge de signal créée en chaque point du DTC, on a:

$$G = \frac{q\,(V-V_o)}{\varepsilon_i}$$

où V est la différence de potentiel entre la photocathode et le DTC;
$\varepsilon_i$ = 3,6 électron-volts, soit l'énergie moyenne nécessaire pour créer une paire électron-trou dans du silicium bombardé par des électrons de quelques kiloélectron-volts;
$V_0$ est un paramètre technologique rendant compte des effets de recombinaison de surface sur la face arrière bombardée. En pratique on a $V_0$ = 3 kV;
$q = 1,6 \times 10^{-19}$ Cb.

Dans le cas des valeurs qui viennent d'être citées ce gain se trouve être proche de 2000.

Pour définir les performances du capteur d'images, il y a lieu de se référer à une source de lumière type éclairant la photocathode. Une telle source est constituée par un corps noir émettant à une température de 2854°K. En intégrant sur le spectre de longueurs d'ondes utile pour le capteur d'image, qui se situe dans la bande 0,5 µm à 1 µm environ, on obtient une transparence moyenne de 30% pour la photocathode semi-transparente. Compte tenu du gain électronique G = 2000, ceci permet de détecter quelques photoélectrons par pixel et par trame.

Lorsque l'on considère l'utilisation en fonctionnement «nuit» il est ainsi possible d'opérer avec des éclairements pouvant descendre à environ $10^{-4}$ lux. La gamme d'éclairement sur la photocathode s'étend donc de 1000 lux environ en mode «jour», à $10^{-4}$ lux environ en mode «nuit». En fonctionnement «jour», la photocathode semi-transparente n'introduit qu'une perte de 30% en moyenne par rapport à un DTC utilisé seul.

Le principe de fonctionnement du capteur d'images destiné à être introduit dans une caméra ayant un fonctionnement «jour» et «nuit», est le suivant. La caméra comprend un dispositif optique permettant de focaliser une scène soit sur la photocathode semi-transparente, soit sur la face arrière du dispositif à transfert de charges.

En mode «jour», l'intensité de l'éclairement étant suffisante, le dispositif optique focalise l'image sur le dispositif à transfert de charges. Celui-ci étant sensible au rayonnement photonique transforme l'image optique en un signal électrique qui est exploité par des moyens électroniques conventionnels. Il n'existe alors aucune haute tension appliquée entre la photocathode et le dispositif à transfert de charges, et aucun photoélectron n'atteint ce dernier.

En mode «nuit» l'éclairement étant faible, le dispositif optique focalise l'image sur la photocathode. Une différence de potentiel, par exemple de 10 Kvolts, est appliquée entre la photocathode et le dispositif à transfert de charges. Les photoélectrons, qui sont émis par la photocathode sous l'action du rayonnement phototonique, sont accélérés et créent dans le dispositif à transfert de charges des paires électrons-trous qui génèrent un signal électrique qui est exploité par les mêmes électroniques conventionnels que précédemment. La faible distance et le fort champ électrique apparaissant entre la photocathode et le dispositif à transfert de charges ainsi que la structure monocristalline et le matériau III-V utilisé font que la composante latérale moyenne de l'énergie initiale des photoélectrons est faible, ce qui assure une bonne définition de l'image finale restituée. Celle-ci est de l'ordre de 30 paires de lignes par millimètre.

Le capteur d'images a été décrit avec une photocathode en arséniure de gallium. Il est bien sur possible d'utiliser d'autres matériaux de type n-aire (ternaire, quaternaire...) pour réaliser cette photocathode dans la mesure où l'état de surface de la couche active permet d'utiliser une focalisation de proximité. Ces couches peuvent être réalisées non seulement par épitaxie en phase liquide mais également par épitaxie aux organo-métalliques en phase vapeur.

L'invention sera mieux comprise à l'aide des dessins, donnés à titre d'exemple non limitatif, qui représentent:

figure 1 une vue partielle en coupe d'un capteur d'images selon l'invention;

figure 2 un réseau de courbes représentant la transmission de la photocathode semi-transparente, la sensibilité du dispositif à transfert de charges et la sensibilité du capteur d'images en fonction de la longueur d'onde du rayonnement incident.

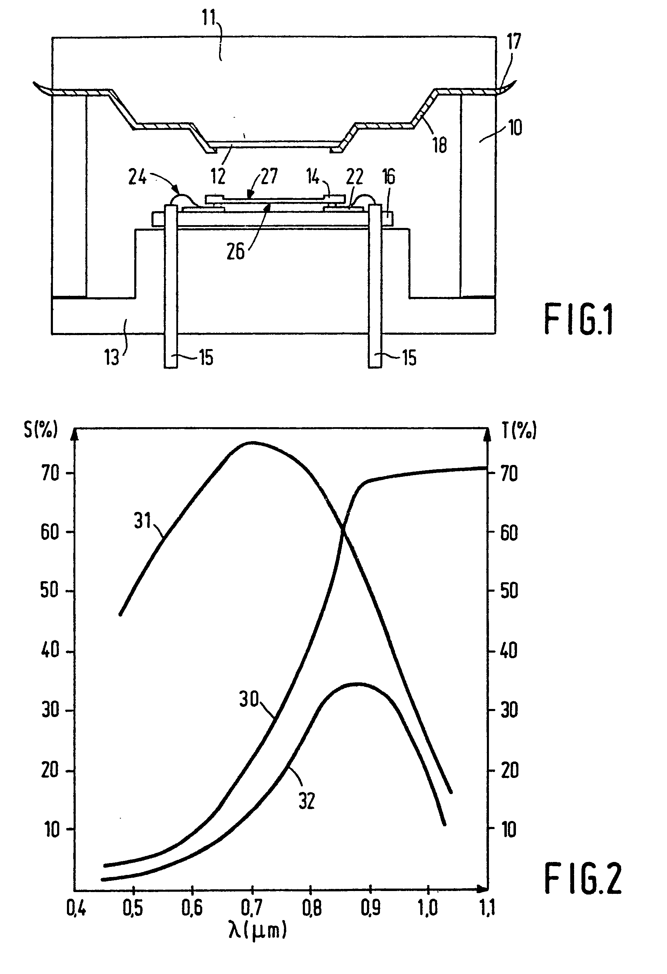

Sur la figure 1 est représenté un capteur d'images selon l'invention. Il est constitué d'une enveloppe à vide formée d'une fenêtre d'entrée 11, d'un support arrière 13 et d'un manchon périphérique 10. La fenêtre d'entrée 11 constitue également le substrat d'une photocathode 12. Le support arrière 13 comporte un certain nombre de passages électriques 15 étanches au vide dont deux sont représentés sur la figure pour ne pas alourdir le dessin. Le support de montage 16, qui reçoit le dispositif à transfert de charges aminci 14, est fixé sur le support arrière 13 du détecteur d'images, en utilisant les passages électriques 15 affectés aux connexions de masse, ceux-ci étant munis d'une rondelle de blocage soudée électriquement. La photocathode semi-transparente 12, réalisée selon la méthode décrite préalablement, est disposée en face du dispositif à transfert de charges aminci du côté de la face arrière 27 de celui-ci. Selon le mode d'utilisation la différence de potentiel peut être appliquée entre celui des passages électriques représentés par le repère 15 qui est relié au substrat du dispositif à transfert de charges et le passage électrique 17 relié à la photocathode à l'aide d'une couronne métallique 18 de nickel chrome déposée par évaporation sous vide. Le dispositif optique non représenté projette l'image soit sur la photocathode 12 soit sur le dispositif à transfert de charges 14.

Le dispositif à transfert de charges présente sur sa face avant 26 et à sa périphérie des plots de connexion réalisés lors des opérations d'élaboration du dispositif lui-même. Par ailleurs le support de montage 16, constitué par exemple d'une plaque de corindon ou de verre présente un motif de pistes conductrices 22, gravées ou sérigraphiées. Les plots de connexion du dispositif à transfert de charges sont connectés au motif de pistes conductrices 22 à l'aide de soudure ou équivalent. Des fils de connexion 24 reprennent par thermocompression les contacts sur la périphérie du support de montage 16 et assurent le contact avec les passages électriques 15.

Sur la figure 2 sont représentées trois courbes dans la gamme de longueurs d'ondes allant de 0,4 µm à 1,1 µm.

— La courbe 30 représente la transmission d'une photocathode semi-transparente en GaAs. Compte-tenu des pertes par réflexion qui apparaissent sur les faces d'une telle photocathode à cause des variations d'indices optiques, on constate que la transmission maximale, égale à 70% est atteinte vers 0,9 µm.

— La courbe 31 représente la sensibilité d'un dispositif à transfert de charges en silicium. Celle-ci est maximale vers 0,7 µm, devenant nulle pour 1,1 µm.

— La courbe 32 représente la sensibilité du capteur d'images selon l'invention. Elle est maximale vers 0,85 µm.

L'invention a été décrite pour une épaisseur de photocathode de 0,5 µm. Il est bien sûr possible de modifier cette valeur, ce qui a pour effet de déplacer la longueur d'onde où apparaît la sensibilité maximale du capteur d'images. Pour rester dans le cadre de l'invention il faut que l'épaisseur de la photocathode soit telle que suffisamment de photons atteignent le détecteur en mode «jour», mais également que suffisamment de photoélectrons soient créés par la photocathode en mode «nuit».

## Revendications

1. Capteur d'images pour caméra munie d'un double fonctionnement, en mode «jour» et en mode «nuit», présentant dans une enveloppe vidée d'air:

a) sur une fenêtre d'entrée, une photocathode semi-transparente pour transmettre les photons incidents ou les convertir en photoélectrons selon respectivement le mode «jour» ou le mode «nuit»,

b) sur un support de sortie, un détecteur pouvant convertir, en un signal électrique d'images, respectivement les photons incidents ou les photoélectrons, selon le mode «jour» ou le mode «nuit»,

c) des moyens électroniques de focalisation des photoélectrons sur le détecteur, et des moyens optiques de focalisation, des photons sur la photocathode ou le détecteur selon respectivement le mode «nuit» ou le mode «jour», caractérisé:

— en ce que la photocathode semi-transparente est constituée d'une lame ayant au moins une couche active d'une épaisseur de l'ordre de 0,5 μm d'un matériau n-aire III-V,

— en ce que le détecteur est constitué d'un dispositif à transfert de charges bidimensionnel, qui comprend un substrat suffisamment mince afin que les photons et les photoélectrons agissent par l'arrière sur la partie active du dispositif à transfert de charges à travers le substrat mince,

— et en ce que la photocathode semi-transparente et le dispositif à transfert de charges sont disposés à une distance de l'ordre de 2 mm de telle sorte que les photoélectrons sont focalisés par proximité, sans électrode de focalisation sur le dispositif à transfert de charges.

2. Caméra «jour-nuit», caractérisée en ce qu'elle comprend un capteur d'images selon la revendication 1.


**Patentansprüche**

1. Bilddetektor für eine Kamera mit «Tag-» und «Nachtbetriebsart», der in einer evakuierten Hülle die folgenden Elemente aufweist:

a) an einem Eingangsfenster eine halbtransparente Photokathode zum Übertragen der eintreffenden Photonen oder zum Umwandeln derselben in Photoelektronen, und zwar abhängig vom «Tag-» oder «Nachtbetrieb»,

b) an einem Ausgangsträger einen Detektor zum abhängig vom «Tag-» oder «Nachtbetrieb» Umwandeln der eintreffenden Photonen bzw. Photoelektronen in ein elektrisches Bildsignal,

c) elektronische Mittel zum Fokussieren der Photoelektronen auf den Detektor, sowie optische Fokussierungsmittel zum abhängig vom «Tag-» oder «Nachtbetrieb» Fokussieren der Photonen auf die Photokathode bzw. den Detektor, dadurch gekennzeichnet, dass

— die halbtransparente Photokathode aus einer dünnen Platte mit wenigstens einer aktiven Schicht mit einer Dicke in der Grössenordnung von 0,5 μm aus einem n-ären III-V-Material besteht,

— der Detektor aus einer zweidimensionalen Ladungsübertragungsanordnung besteht, die ein ausreichend dünnes Substrat aufweist, damit die Photonen und Photoelektronen durch das dünne Substrat hindurch von hinten den aktiven Teil der Ladungsübertragungsanordnung beeinflussen,

— die halbtransparente Photokathode und die Ladungsübertragungsanordnung in einem Abstand von 2mm voneinander angeordnet sind, so dass die Photoelektronen ohne Fokussierungselektrode auf die Ladungsübertragungsanordnung näherungs-fokussiert werden.

2. Kamera für «Tag-» und «Nachtbetrieb», dadurch gekennzeichnet, dass sie einen Bilddetektor nach Anspruch 1 aufweist.


**Claims**

1. An image detector for a camera operating in two modes, a «day» mode and a «night» mode, comprising in an evacuated enveloppe:

a) on an inlet window, a semi-transparent photocathode for transmitting the incident photons or for converting them into photoelectrons, depending on the «day» or «night» mode, respectively,

b) on an outlet support, a detector capable of converting the incident photons or the photoelectrons into an electrical image signal, depending on the «day» or «night» mode, respectively,

c) electronic means for focussing the photoelectrons on the detector, and optical means for focussing the photons on the photocathode or the detector, depending on the «night» or «day» mode, respectively, characterized:

— in that the semi-transparent photocathode consists of a sheet having at least one active layer with a thickness of the order of 0.5 μm of an n-ary III-V material,

— in that the detector consists of a two-dimensional charge transfer device, comprising a substrate which is sufficiently thin for the photons and photoelectrons to act from the rear on the active part of the charge transfer device through the thinned substrate,

— and in that the semitransparent photocathode and the charge transfer device are arranged at a distance of the order of 2 mm, such that the photoelectrons are proximity-focused on the charge transfer device without using a focusing electrode.

2. A «day-night» camera, characterized in that it comprises an image detector as claimed in Claim 1.

FIG.1

FIG.2